# EUROPEAN PATENT APPLICATION

(11) **EP 4 779 877 A1**
(43) Date of publication of application: **22.07.2026**
(21) Application number: 26150036.7
(22) Date of filing: 02.01.2026
(51) Int. Cl.: H03M 1/46

(54) **HYBRID SUCCESSIVE APPROXIMATION REGISTER ANALOG-TO-DIGITAL CONVERTER**

(30) Priority: 17.01.2025 US 202519030266
(71) Applicant: Avago Technologies International Sales Pte. Limited, Singapore 768923 (SG)
(72) Inventor: Fang, Jie, Austin, TX, 78739 (US); Zhu, Hongjie, Austin, TX, 78739 (US); Singor, Frank, Austin, TX, 78735 (US)
(74) Representative: Grünecker Patent- und Rechtsanwälte PartG mbB

(57) **Abstract**

In an example, an analog-to-digital converter (ADC) includes a comparator having a first input, a second input, and an output, the comparator configured to compare the first input and the second input to generate the output; a first digital-to-analog converter (DAC) coupled to the first input of the comparator, the first DAC including a first plurality of unsplit capacitors and at least one first split capacitor; a second DAC coupled to the second input of the comparator, the second DAC including a second plurality of unsplit capacitors and at least one second split capacitor; first switches coupled to the first DAC; second switches coupled to the second DAC; and a first circuit configured to, in response to the output of the comparator, generate control signals for the first and second switches.

## Description

### BACKGROUND

An analog-to-digital converter (ADC) may be a circuit that converts an analog signal into a digital signal. An analog signal may be a signal that is continuous in time and represents some other quantity (referred to as amplitude or level of the signal). A digital signal may be a signal that is discrete in time and represents some other quantity as discrete values. A successive approximation register (SAR) ADC may be an ADC that digitizes each sample of an analog signal using a binary search through a set of quantization levels. A SAR ADC can include a digital-to-analog converter (DAC) coupled to a comparator. A DAC may be a circuit converts a digital input to an analog output. Some SAR ADCs can include capacitive DACs. A capacitive DAC may be a DAC that uses an array of capacitors to generate discrete analog voltages corresponding to digital input codes. A comparator may be a circuit that compares two voltages and provides a digital output indicating which voltage is larger.

In operation, the input switches and the capacitive DAC can perform a sample and hold of the analog signal input to the SAR ADC. Logic in the SAR ADC can then control charge redistribution in the capacitive DAC using digital codes input thereto over a plurality of cycles. The comparator can perform comparisons, the results of which are used to determine the digital codes input to the capacitive DAC. After the last cycle, the logic in the SAR ADC can determine a digital representation of the analog input. The capacitive DAC can consume high power and large implementation area on an integrated circuit (IC).

### SUMMARY

In an embodiment, an analog-to-digital converter (ADC) can include a comparator having a first input, a second input, and an output, the comparator configured to compare the first input and the second input to generate the output. The ADC can include a first digital-to-analog converter (DAC) coupled to the first input of the comparator, the first DAC including a first plurality of unsplit capacitors and at least one first split capacitor. The ADC can include a second DAC coupled to the second input of the comparator, the second DAC including a second plurality of unsplit capacitors and at least one second split capacitor. The ADC can include first switches coupled to the first DAC and second switches coupled to the second DAC. The ADC cc an include a first circuit configured to, in response to the output of the comparator, generate control signals for the first and second switches.

In another embodiment, a receiver can include an analog front end (AFE) configured to condition an analog signal. The receiver can include a successive approximation analog-to-digital converter (SAR ADC) configured to generate a digital signal from the analog signal. The receiver can include a digital signal processor configured to process the digital signal. The SAR ADC can include a comparator having a first input, a second input, and an output, the comparator configured to compare the first input and the second input to generate the output. The SAR ADC can include a first digital-to-analog converter (DAC) coupled to the first input of the comparator, the first DAC including a first plurality of unsplit capacitors and at least one first split capacitor. The SAR ADC can include a second DAC coupled to the second input of the comparator, the second DAC including a second plurality of unsplit capacitors and at least one second split capacitor. The SAR ADC can include first switches coupled to the first DAC and second switches coupled to the second DAC. The SAR ADC can include a first circuit configured to, in response to the output of the comparator, generate control signals for the first and second switches.

In another embodiment, an analog-to-digital converter (ADC) can include a comparator having an input and an output. The ADC can include a capacitive digital-to-analog converter (DAC) coupled to the input of the comparator. The ADC can include a first circuit coupled to the output of the comparator. The capacitive DAC can include a plurality of unsplit capacitors, at least one split capacitor, and first switches coupled to the plurality of unsplit capacitors and the at least one split capacitor. The first circuit can be configured to, in response to the output of the comparator, generate control signals for the switches.

### BRIEF DESCRIPTION OF THE DRAWINGS

Fig. 1 is a block diagram depicting a receiver according to some embodiments.
Fig. 2 is a schematic diagram depicting a SAR ADC according to some embodiments.
Fig. 3 is a schematic diagram depicting a DAC according to some embodiments.
Fig. 4 is a schematic diagram depicting a SAR ADC according to further embodiments.
Fig. 5 is a flow diagram depicting a method of operation for a SAR ADC according to some embodiments.
Fig. 6 is a flow diagram depicting a method of operation for a SAR ADC according to further embodiments.

### DETAILED DESCRIPTION

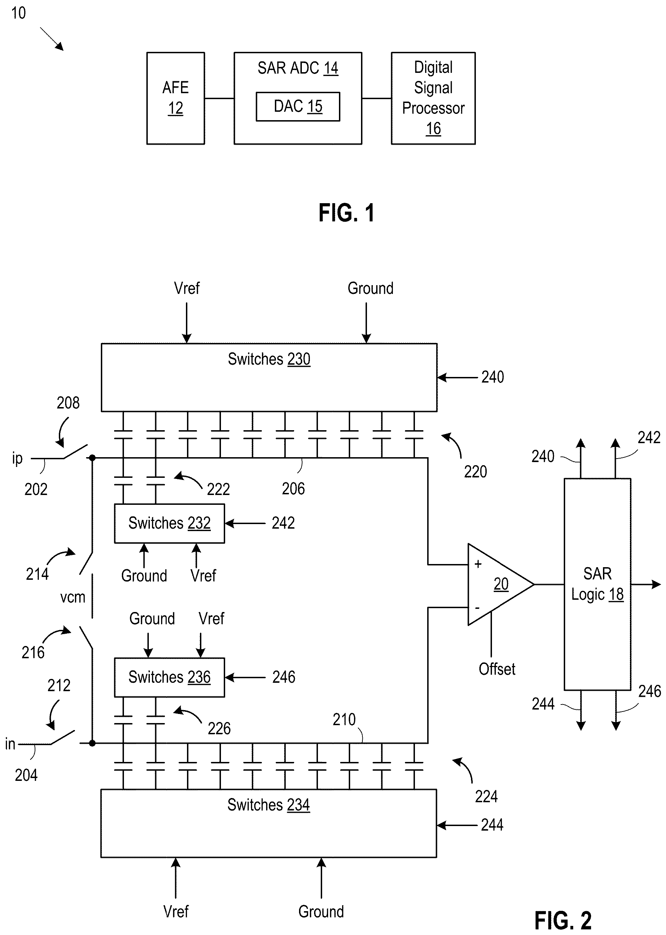

Fig. 1 is a block diagram depicting a receiver 10 according to some embodiments. A receiver may be a circuit that observes a signal on a transmission medium. Receiver 10 can observe an analog signal. Receiver 10 can include an analog front-end (AFE) 12, a SAR analog-to-digital converter (ADC) 18, and a digital signal processor 16. An AFE may be a circuit configured to condition an analog signal. AFE 12 can condition the analog signal (e.g., filter, amplify, down-convert, etc. the analog signal). SAR ADC 14 can sample the analog output from AFE 12 and generate a digital signal. A digital signal processor may be a circuit that can process digital samples. Digital signal processor 16 can process digital output from SAR ADC 14. SAR ADC 14 can include a digital-to-analog converter (DAC) 15.

One type of DAC for a SAR ADC can include capacitors coupled to inputs of a comparator, as discussed above. In some embodiments, output of AFE 12 can be a differential signal having a positive component and a negative component. A differential signal may be a signal being the difference between the positive and negative components. Consider a DAC where first plates of a first set of capacitors (referred to as top plates of positive input capacitors) can be coupled to a first input of the comparator (a positive input). Top plates of a second set of capacitors (referred to as negative input capacitors) can be coupled to a second input of the comparator (a negative input). The DAC can include switches that can selectively couple either the positive component or the negative component of the differential analog signal to the second plates of the sets of capacitors (referred to as bottom plates). The DAC can include additional switches that can selectively couple a common-mode voltage to each input of the comparator. The capacitors in each set can include a capacitor of one unit and a set of binary-weighted (e.g., capacitances of 1, 2, 4, 8, 16, etc. units) or sub-2-radix-weighted (e.g. capacitances of 1, 2, 4, 8, 14, 28, etc. units ). In examples and embodiments herein, the top plates of capacitors can be those coupled to the inputs of the comparator and the bottom plates of the capacitors can be those opposite the top plates.

Analog-to-digital conversion can occur over multiple cycles. Initially, the top plates of the capacitors can be driven to the common mode voltage, the positive component can be coupled to the bottom plates of the positive input capacitors, and the negative component can be coupled to the bottom plates of the negative input capacitors. In a next cycle, the bottom plates of all positive input capacitors other than the most-significant capacitor can be coupled to electrical ground. The bottom plate of the most-significant positive input capacitor can be coupled to a reference voltage (Vref). The bottom plates of all negative input capacitors other than the most-significant capacitor can be coupled to the reference voltage (Vref). The bottom plate of the most-significant capacitor can be coupled to electrical ground. In each additional cycle, the bottom plates of the capacitors can be controlled depending on the result of the comparison in the previous cycle.

In a conventional bottom-plate SAR algorithm, the bottom plates of the DAC capacitors are switched such that the top plate voltage goes from common-mode to maximum in the first cycle. That is, in the first cycle, the top plates of the positive capacitors in MSB and the negative capacitors in the rest of LSBs go from common-mode to maximum positive voltage and the top plates of the negative capacitors in MSB and the positive capacitors in the rest of LSBs go from common-mode to maximum negative voltage. Thereafter, the top plate differential voltage successively decreases to zero. This type of DAC and operation can exhibit large switching power consumption and large power consumption by the reference voltage source. Further, a common-mode voltage source is needed, resulting in further power consumption and implementation area. Further, such a DAC needs additional time for switching the positive/negative components into Vref/ground before making the first conversion cycle, which can affect conversion speed of the SAR ADC. This configuration and algorithm for the DAC can be referred to as a bottom-plate configuration.

In another DAC configuration (referred to as a top-plate configuration), the positive and negative components can be selectively coupled to the positive and negative inputs of the comparator, respectively. The bottom plates of the DAC capacitors are switched between Vref and ground. Initially, the positive and negative components can be coupled to the comparator inputs. Then the positive negative components can be disconnected and the algorithm performed In the algorithm (monotonic switching algorithm), only the bottom plates of the positive input capacitors are switched from cycle to cycle until the last cycle. This results in a smaller DAC switching power consumption and lower power consumed by the Vref source. Further, in the top-plate configuration, the common-mode voltage source can be omitted. The first conversion cycle can be performed right after the sampling period, which can result in higher speed (e.g., no transition from common-mode voltage). However, the top-plate common-mode voltage of the positive input capacitors can change significantly, which can lead to data-dependent offset, nonlinear capacitance, comparator noise, and decrease in conversion speed.

Another type of bottom-plate DAC configuration for a SAR ADC can include split capacitors. In such a configuration, all the capacitors in each positive and negative set can be split into multiple capacitors. This configuration (bottom-plate configuration with split capacitors), however, can require more complex SAR logic and high-speed routing to generate control signals for the extra switches of the split capacitors. This can result in higher power consumption and a large implementation area of the SAR ADC.

Fig. 2 is a schematic diagram depicting SAR ADC 14 according to some embodiments. SAR ADC 14 can have a top-plate configuration with one or more split capacitors. SAR ADC 14 includes a first input 202 and a second input 204. First input 202 can receive a positive component of a differential output from AFE 12 (e.g., ip). Second input 204 can receive a negative component of a differential output from AFE 12 (e.g., in). First input 202 can be coupled to a node 206 through a switch 208. Second input can be coupled to a node 210 through a switch 212. Node 206 can be coupled to a common-mode voltage source (Vcm) through a switch 214. Node 210 can be coupled to Vcm through a switch 216. DAC 15 can include a bank 220 of capacitors, a bank 222 of capacitors, a bank 224 of capacitors, and a bank 226 of capacitors. Banks 220 and 222 can be the positive input capacitors and banks 224 and 226 can be the negative input capacitors. Top plates of banks 220 and 222 can be coupled to node 206. Top plates of banks 224 and 226 can be coupled to node 210. A first input of a comparator 20 can be coupled to node 206 (the positive input). A second input of comparator 20 can be coupled to node 210 (the negative input). An output of comparator 20 can be coupled to an input of SAR logic 18. Bottom plates of bank 220 can be coupled to switches 230. Bottom plates of bank 222 can be coupled to switches 232. Bottom plates of bank 224 can be coupled to switches 234. Bottom plates of bank 226 can be coupled to switches 236. SAR logic 18 can include control outputs for controlling switches 230, 232, 234, and 236. SAR logic 18 can include a control output 240 for controlling switches 230; a control output 242 for controlling switches 232; a control output 244 for controlling switches 234; and a control output 246 for controlling switches 236. SAR logic 18 can include an output that can provide a digital signal. Comparator 20 can include another input for adjusting an offset voltage. Switches 230, 232, 234, and 236 can selectively couple either Vref or electrical ground to the bottom plates of individual capacitors.

In some embodiments, some capacitors in bank 220 and bank 224 can be binary weighted (e.g., 1, 2, 4, 8, 16, 32etc. units) or sub-2 radix weighted (e.g. 1, 2, 4, 8, 14, 28, etc. units). While 10 capacitors are shown in the example for each bank 220 and 224, banks 220 and 224 can include more or less than 10 capacitors. In the example, 8 capacitors in each bank 220 and 224 can be binary weighted (e.g., 1, 2, 4, 8, 16, 32, 64, and 128 units). Two capacitors in each bank 220 and 224 can be split capacitors. A split capacitor may be a capacitor implemented using multiple capacitors. Thus, a weight 256 capacitor can be formed from two weight 128 capacitors (one in bank 220 and another in bank 222). A weight 512 capacitor can be formed from two weight 256 capacitors (one in bank 220 and another in bank 222). In the example, the set of capacitors coupled to node 206 can include two split capacitors and the set of capacitors coupled to node 210 can include two split capacitors. In other embodiments, there can be more or less than two split capacitors.

The embodiment of Fig. 2 can provide a hybrid architecture for a top-plate configuration of a SAR ADC. Most significant capacitors in the array (e.g., the two most significant capacitors) can have a split capacitor architecture. The remaining ones of the capacitors (the least significant capacitors) can omit the split capacitor architecture (e.g., unsplit capacitors). Thus, in embodiments, some number (less than all) of the most significant capacitors can be split capacitors and the remaining capacitors can be unsplit capacitors. To avoid complex SAR logic and high-speed routing, SAR logic 18 can generate control signals 242 only for those capacitors that are split capacitors and control signals 246 only for those capacitors that are split capacitors. This is opposed to a configuration where all capacitors are split and the SAR logic must include additional routing. This reduces implementation area and routing complexity. The smaller implementation area also leads to less parasitic resistance and capacitance, improving speed and lowering power consumption. Not splitting the least significant capacitors results in less implementation area and less wasted space between capacitors.

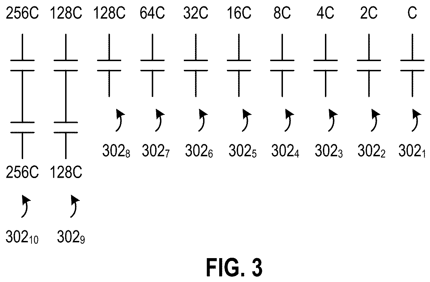

Fig. 3 is a schematic diagram depicting a DAC according to some embodiments. The DAC can be banks 220 and 222 or banks 224 and 226 as shown in Fig. 2. The DAC includes bit positions 302₁...302₁₀ (e.g., a 10-bit DAC in the example). Although 10 bit positions are shown in the example of Fig. 2-3, the DAC can include more or less than 10 bit positions. A bit position may be a weight in a binary-weighted or sub-2-radix-weighted array of capacitances. In the example, bit position 302₁ represents a weight of C (some unit of capacitance). Bit position 302₂ represents a weight of 2C. Bit position 302₃ represents a weight of 4C. This continues in a binary-weighted pattern up until bit position 302₁₀ representing a weight of 512C. In some embodiments, one or more of the most significant bit positions (those bit position(s) with the highest weight(s)) can be split capacitors. In the example, the two most significant bit positions 302₉ and 302₁₀ can be spit capacitors. In some embodiments, each constituent capacitor in a split capacitor can be half the weight of the bit position. Thus, for bit position 302₉, the 256C split capacitor can be implemented using two 128C capacitors. For bit position 302₁, the 512C split capacitor can be implemented using two 256C capacitors. Those capacitors that are not split capacitors can be referred to as unsplit capacitors. In the example, bit positions 302₁...302₈ can be implemented using unsplit capacitors.

Notably, a bit position in a capacitive DAC having an unsplit capacitor includes two plates, a bottom plate and a top plate. One plate can be coupled to an input of the comparator and another plate can be coupled to a switch. A bit position in a capacitive DAC having a split capacitor includes the number of constituent capacitors times two plates. In the example, each split capacitor includes two constituent capacitors, thus each bit position with such a split capacitor includes four plates. Note that, in some embodiments, a split capacitor can include more than two capacitors (e.g., the weight of a bit position can be divided among more than two capacitors of a split capacitor). In the example of Fig. 2, the bottom plate of each split and unsplit capacitor can be coupled to a switch and the top plate of each split and unsplit capacitor can be coupled to an input of comparator 20.

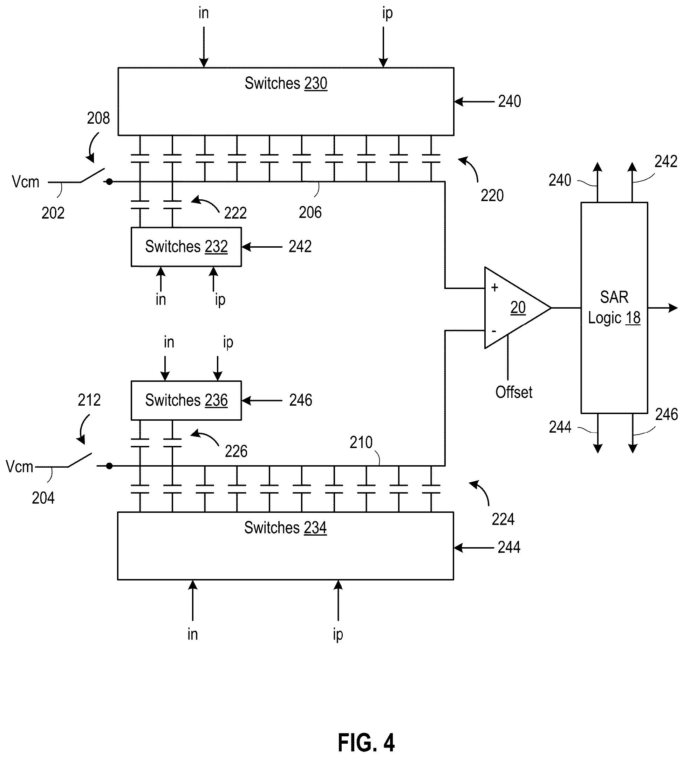

Fig. 4 is a schematic diagram depicting SAR ADC 14 according to further embodiments. Elements of Fig. 4 that are the same or similar to those in Fig. 2 are designated with identical reference numerals. Fig. 4 shows an embodiment for a bottom-plate configuration (as opposed to the top-plate configuration shown in Fig. 2). In the bottom-plate configuration, a common-mode voltage can be selectively coupled to nodes 206 and 210. Switches 230, 232, 234, and 236 selectively couple the bottom plates of each capacitor to one of the positive component (in) or the negative component (ip). Otherwise, the embodiment is the same as shown in Fig. 2 and described above (e.g., some number less than all of the most significant capacitors can be split capacitors and the remaining capacitors can be unsplit capacitors).

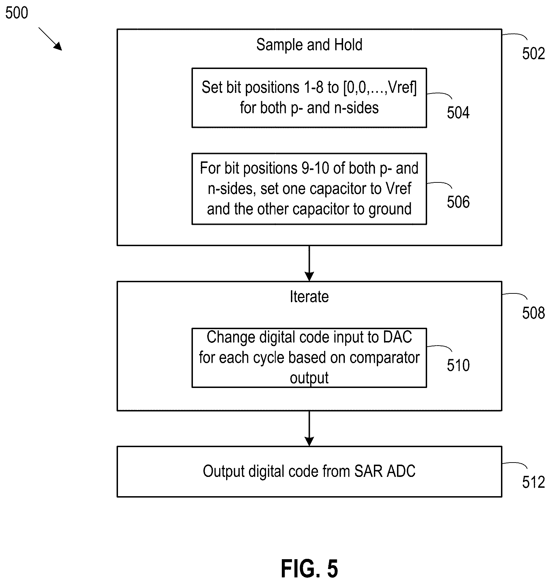

Fig. 5 is a flow diagram depicting a method 500 of operation for SAR ADC 14 according to some embodiments. Method 500 begins at step 502, where SAR logic 18 can perform sample and hold. During step 502, at step 504, SAR logic 18 can set bit positions 1-8 to [0, 0,..., Vref], respectively. That is, bit positions 1-7 can be set to ground and bit position 8 can be set to Vref. SAR logic 18 can set these bit positions for both n- and p-sides (e.g., n-side being switches 234-236 and p-side being switches 230-232). At step 506, SAR logic 18 can set, for bit positions 9-10 of both p- and n-sides, one capacitor to Vref and the other capacitor to ground. At step 508, SAR logic 18 can perform iteration through a plurality of cycles (e.g., a binary search algorithm). At step 510, SAR logic 18 can change the digital code input to the DAC for each cycle based on output of comparator 20. At step 512, SAR logic 18 can output a digital code from SAR ADC 14.

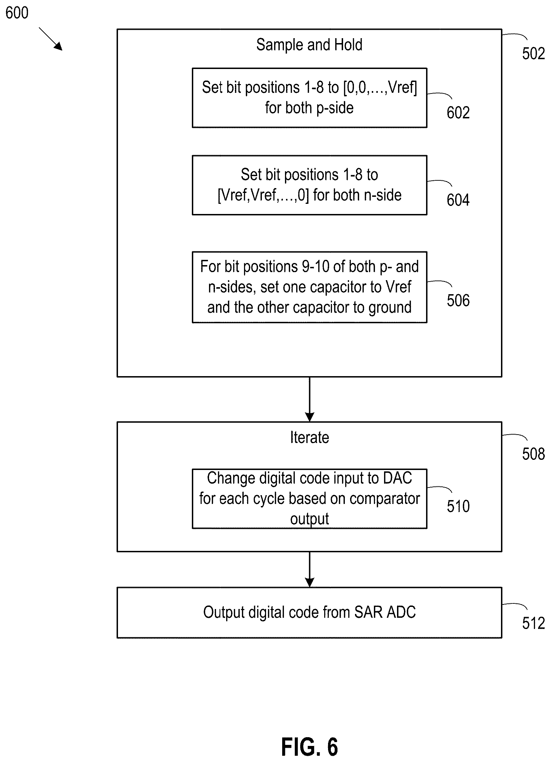

Fig. 6 is a flow diagram depicting a method 600 of operation for SAR ADC 14 according to further embodiments. Elements of Fig. 6 that are the same or similar to those of Fig. 5 are designated with identical reference numerals and described in detail above. In the present embodiment, step 504 can be replaced with steps 602 and 604. At step 602, SAR logic 18 can set bit positions 1-8 to [0, 0,..., Vref] for the p-side. At step 604, SAR logic 18 can set bit positions 1-8 to [Vref, Vref,..., 0] for the n-side. Method 500 can proceed as described above.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C ," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

The following are further embodiments of the invention:
1. An analog-to-digital converter (ADC), comprising:
   a comparator having a first input, a second input, and an output, the comparator configured to compare the first input and the second input to generate the output;
   a first digital-to-analog converter (DAC) coupled to the first input of the comparator, the first DAC including a first plurality of unsplit capacitors and at least one first split capacitor;
   a second DAC coupled to the second input of the comparator, the second DAC including a second plurality of unsplit capacitors and at least one second split capacitor;
   first switches coupled to the first DAC;
   second switches coupled to the second DAC; and
   a first circuit configured to, in response to the output of the comparator, generate control signals for the first and second switches.
2. The ADC of embodiment 1, further comprising:
   a third switch coupled to the first input of the comparator, the third switch configured to couple a first component of an analog signal to the first input of the comparator;
   a fourth switch coupled to the second input of the comparator, the fourth switch configured to couple a second component of the analog signal to the second input of the comparator.
3. The ADC of embodiment 2, wherein the first switches are configured to couple a reference voltage and electrical ground to the first DAC and the second switches are configured to couple the reference voltage and the electrical ground to the second DAC.
4. The ADC of embodiment 1, further comprising:
   a third switch coupled to the first input of the comparator, the third switch configured to couple a reference voltage to the first input of the comparator;
   a fourth switch coupled to the second input of the comparator, the fourth switch configured to couple the reference voltage to the second input of the comparator.
5. The ADC of embodiment 4, wherein the first switches are configured to couple a first component of an analog signal and electrical ground to the first DAC and the second switches are configured to couple a second component of the analog signal and the electrical ground to the second DAC.
6. The ADC of embodiment 1, wherein the first circuit includes first connections to the first plurality of unsplit capacitors, second connections to the second plurality of unsplit capacitors, at least one third connection to the at least one first split capacitor, and at least one fourth connection to the at least one second split capacitor.
7. The ADC of embodiment 1, wherein the capacitances of the first plurality of unsplit capacitors and the second plurality of unsplit capacitors are binary weighted or sub-2-radix weighted.
8. A receiver, comprising:
   an analog front end (AFE) configured to condition an analog signal;
   a successive approximation analog-to-digital converter (SAR ADC) configured to generate a digital signal from the analog signal; and
   a digital signal processor configured to process the digital signal;
   wherein the SAR ADC comprises:
      a comparator having a first input, a second input, and an output, the comparator configured to compare the first input and the second input to generate the output;
      a first digital-to-analog converter (DAC) coupled to the first input of the comparator, the first DAC including a first plurality of unsplit capacitors and at least one first split capacitor;
      a second DAC coupled to the second input of the comparator, the second DAC including a second plurality of unsplit capacitors and at least one second split capacitor; and
      first switches coupled to the first DAC;
      second switches coupled to the second DAC; and
      a first circuit configured to, in response to the output of the comparator, generate control signals for the first and second switches.
9. The receiver of embodiment 8, further comprising:
   a third switch coupled to the first input of the comparator, the third switch configured to couple a first component of an analog signal to the first input of the comparator;
   a fourth switch coupled to the second input of the comparator, the fourth switch configured to couple a second component of the analog signal to the second input of the comparator.
10. The receiver of embodiment 9, wherein the first switches are configured to couple a reference voltage and electrical ground to the first DAC and the second switches are configured to couple the reference voltage and the electrical ground to the second DAC.
11. The receiver of embodiment 9, further comprising:
   a third switch coupled to the first input of the comparator, the third switch configured to couple a reference voltage to the first input of the comparator;
   a fourth switch coupled to the second input of the comparator, the fourth switch configured to couple the reference voltage to the second input of the comparator.
12. The receiver of embodiment 11, wherein the first switches are configured to couple a first component of an analog signal and electrical ground to the first DAC and the second switches are configured to couple a second component of the analog signal and the electrical ground to the second DAC.
13. The receiver of embodiment 8, wherein the first circuit includes first connections to the first plurality of unsplit capacitors, second connections to the second plurality of unsplit capacitors, at least one third connection to the at least one first split capacitor, and at least one fourth connection to the at least one second split capacitor.
14. The receiver of embodiment 8, wherein the capacitances of the first plurality of unsplit capacitors and the second plurality of unsplit capacitors are binary weighted or sub-2-radix weighted.
15. An analog-to-digital converter (ADC), comprising:
   a comparator having an input and an output;
   a capacitive digital-to-analog converter (DAC) coupled to the input of the comparator;
   a first circuit coupled to the output of the comparator;
   wherein the capacitive DAC includes a plurality of unsplit capacitors, at least one split capacitor, and first switches coupled to the plurality of unsplit capacitors and the at least one split capacitor; and
   wherein the first circuit is configured to, in response to the output of the comparator, generate control signals for the switches.
16. The ADC of embodiment 15, further comprising:
   a second switch configured to couple an analog signal to the input of the comparator.
17. The ADC of embodiment 16, wherein the first switches are configured to couple a reference voltage and electrical ground to the plurality of unsplit capacitors and the at least one split capacitor.
18. The ADC of embodiment 15, further comprising:
   a second switch configured to couple a reference voltage to the input of the comparator.
19. The ADC of embodiment 18, wherein the first switches are configured to couple the analog signal and electrical ground to the plurality of unsplit capacitors and the at least one split capacitor.
20. The ADC of embodiment 1, wherein the capacitances of the plurality of unsplit capacitors and the second plurality of unsplit capacitors are binary weighted or sub-2-radix weighted.

## Claims

1. An analog-to-digital converter (ADC), comprising:
a comparator having a first input, a second input, and an output, the comparator configured to compare the first input and the second input to generate the output;
a first digital-to-analog converter (DAC) coupled to the first input of the comparator, the first DAC including a first plurality of unsplit capacitors and at least one first split capacitor;
a second DAC coupled to the second input of the comparator, the second DAC including a second plurality of unsplit capacitors and at least one second split capacitor;
first switches coupled to the first DAC;
second switches coupled to the second DAC; and
a first circuit configured to, in response to the output of the comparator, generate control signals for the first and second switches.

2. The ADC of claim 1, further comprising:
a third switch coupled to the first input of the comparator, the third switch configured to couple a first component of an analog signal to the first input of the comparator;
a fourth switch coupled to the second input of the comparator, the fourth switch configured to couple a second component of the analog signal to the second input of the comparator,
in particular,
wherein the first switches are configured to couple a reference voltage and electrical ground to the first DAC and the second switches are configured to couple the reference voltage and the electrical ground to the second DAC.

3. The ADC of one of the previous claims, further comprising:
a third switch coupled to the first input of the comparator, the third switch configured to couple a reference voltage to the first input of the comparator;
a fourth switch coupled to the second input of the comparator, the fourth switch configured to couple the reference voltage to the second input of the comparator,
in particular,
wherein the first switches are configured to couple a first component of an analog signal and electrical ground to the first DAC and the second switches are configured to couple a second component of the analog signal and the electrical ground to the second DAC.

4. The ADC of one of the previous claims, wherein the first circuit includes first connections to the first plurality of unsplit capacitors, second connections to the second plurality of unsplit capacitors, at least one third connection to the at least one first split capacitor, and at least one fourth connection to the at least one second split capacitor
and/or
wherein the capacitances of the first plurality of unsplit capacitors and the second plurality of unsplit capacitors are binary weighted or sub-2-radix weighted.

5. A receiver, comprising:
an analog front end (AFE) configured to condition an analog signal;
a successive approximation analog-to-digital converter (SAR ADC) configured to generate a digital signal from the analog signal; and
a digital signal processor configured to process the digital signal;
wherein the SAR ADC comprises:
a comparator having a first input, a second input, and an output, the comparator configured to compare the first input and the second input to generate the output;
a first digital-to-analog converter (DAC) coupled to the first input of the comparator, the first DAC including a first plurality of unsplit capacitors and at least one first split capacitor;
a second DAC coupled to the second input of the comparator, the second DAC including a second plurality of unsplit capacitors and at least one second split capacitor; and
first switches coupled to the first DAC;
second switches coupled to the second DAC; and
a first circuit configured to, in response to the output of the comparator, generate control signals for the first and second switches.

6. The receiver of claim 5, further comprising:
a third switch coupled to the first input of the comparator, the third switch configured to couple a first component of an analog signal to the first input of the comparator;
a fourth switch coupled to the second input of the comparator, the fourth switch configured to couple a second component of the analog signal to the second input of the comparator,
in particular,
wherein the first switches are configured to couple a reference voltage and electrical ground to the first DAC and the second switches are configured to couple the reference voltage and the electrical ground to the second DAC.

7. The receiver of claim 6, further comprising:
a third switch coupled to the first input of the comparator, the third switch configured to couple a reference voltage to the first input of the comparator;
a fourth switch coupled to the second input of the comparator, the fourth switch configured to couple the reference voltage to the second input of the comparator.

8. The receiver of claim 7, wherein the first switches are configured to couple a first component of an analog signal and electrical ground to the first DAC and the second switches are configured to couple a second component of the analog signal and the electrical ground to the second DAC.

9. The receiver of one of claims 5 to 8, wherein the first circuit includes first connections to the first plurality of unsplit capacitors, second connections to the second plurality of unsplit capacitors, at least one third connection to the at least one first split capacitor, and at least one fourth connection to the at least one second split capacitor
and/or
wherein the capacitances of the first plurality of unsplit capacitors and the second plurality of unsplit capacitors are binary weighted or sub-2-radix weighted.

10. An analog-to-digital converter (ADC), comprising:
a comparator having an input and an output;
a capacitive digital-to-analog converter (DAC) coupled to the input of the comparator;
a first circuit coupled to the output of the comparator;
wherein the capacitive DAC includes a plurality of unsplit capacitors, at least one split capacitor, and first switches coupled to the plurality of unsplit capacitors and the at least one split capacitor; and
wherein the first circuit is configured to, in response to the output of the comparator, generate control signals for the switches.

11. The ADC of claim 10, further comprising:
a second switch configured to couple an analog signal to the input of the comparator.

12. The ADC of claim 11, wherein the first switches are configured to couple a reference voltage and electrical ground to the plurality of unsplit capacitors and the at least one split capacitor.

13. The ADC of one of claims 10 to 12, further comprising:
a second switch configured to couple a reference voltage to the input of the comparator.

14. The ADC of claim 13, wherein the first switches are configured to couple the analog signal and electrical ground to the plurality of unsplit capacitors and the at least one split capacitor.

15. The ADC of one of claims 1 to 4 or 10 to 14, wherein the capacitances of the plurality of unsplit capacitors and the second plurality ofunsplit capacitors are binary weighted or sub-2-radix weighted.
